(19) **Europäisches Patentamt**

**European Patent Office**

**Office européen des brevets**

(11) **EP 1 585 227 A1**

(12) **EUROPEAN PATENT APPLICATION**

(43) Date of publication:
**12.10.2005 Bulletin 2005/41**

(51) Int Cl.⁷: **H04B 1/28**, H03D 7/16

(21) Application number: **04447093.8**

(22) Date of filing: **08.04.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (71) Applicant: **Op 't Eynde, Frank, Dr.-Ir.**<br>**3012 Wilsele-Leuven (BE)**<br><br>(72) Inventor: **Op 't Eynde, Frank, Dr.-Ir.**<br>**3012 Wilsele-Leuven (BE)** |

(54) **A two-step frequency converter with only one mixer in the signal path**

(57) A dual-conversion frequency conversion is realised with only one mixer in the signal path. The two Local-Oscillator signals are first combined, and this combined signal is used as Local-oscillator signal for the mixer.

EP 1 585 227 A1

**Description**

## Description of the problem

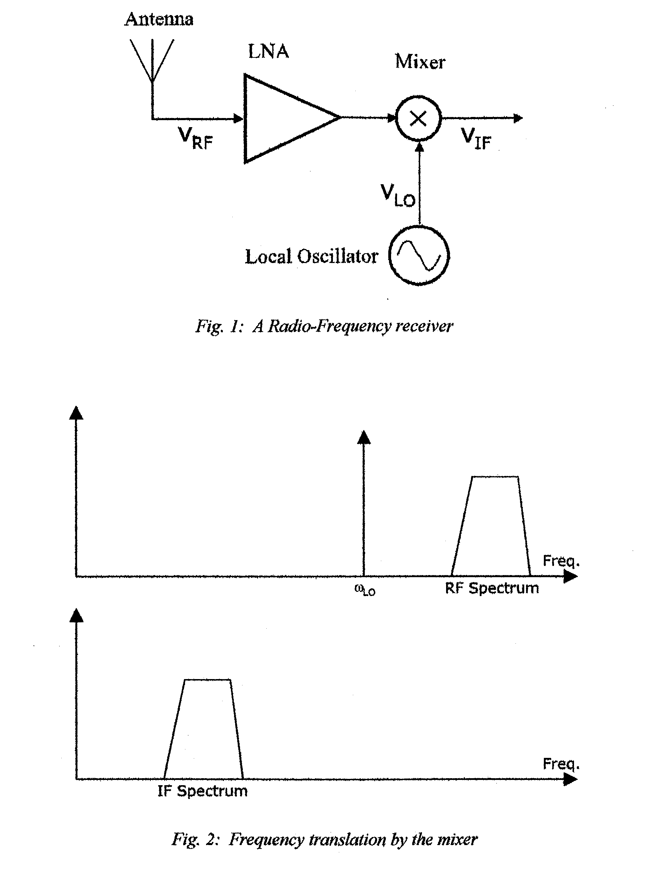

The present invention is related to the reception or emission of radio-frequency signals by means of electronics circuits. Most modem radio-frequency signal receivers (abbreviated as RF receivers), contain a mixer means, to convert the radio-frequency (RF) signal to a lower-frequency signal. The principle schematic of such a RF receiver is depicted in Fig. 1. In most receivers, the electromagnetic signal, received by the antenna, is amplified first by a so-called "Low-Noise Amplifier (LNA)". Then, the signal is multiplied by a local-oscillator signal (ideally a sinusoidal signal) in a multiplying device called "mixer".

If we denote the received RF signal as $A_{RF}.cos(\omega_{RF}.t)$ (*) and the Local Oscillator signal as $A_{LO}.\cos(\omega_{LO}.t)$, then the mixer output signal is given by:

$$\text{Mixer Output signal} = A_{LO}.\cos(\omega_{LO}.t) * A_{RF}.\cos(\omega_{RF}.t) =$$

$$\frac{A_{LO} * A_{RF}}{2}.\cos\{(\omega_{LO} + \omega_{RF}).t\} + \frac{A_{LO} * A_{RF}}{2}.\cos\{(\omega_{RF} - \omega_{LO}).t\} \qquad (1)$$

In practice, only the second term of (1) is of interest. Hence, the RF input spectrum is shifted from a frequency $\omega_{RF}$ to $(\omega_{RF}-\omega_{LO})$ (see Fig. 2). The RF signal is transformed from a high RF frequency to a lower frequency, where the signals are easier to treat. This new frequency $((\omega_{RF}-\omega_{LO})$ is called the "Intermediate Frequency (IF)".

If IF is equal to zero, the receiver is called a "Zero-IF receiver"; otherwise, it is denoted as a "Superheterodyne receiver". This principle is well-known since more than 60 years. A mixer is sometimes also denoted as a "Frequency Downconverter" or briefly "downconverter".

A similar principle can be applied in a radio-frequency transmitter. There, the mixer is Upconverting the signal frequency from a lower value to a high RF-frequency.

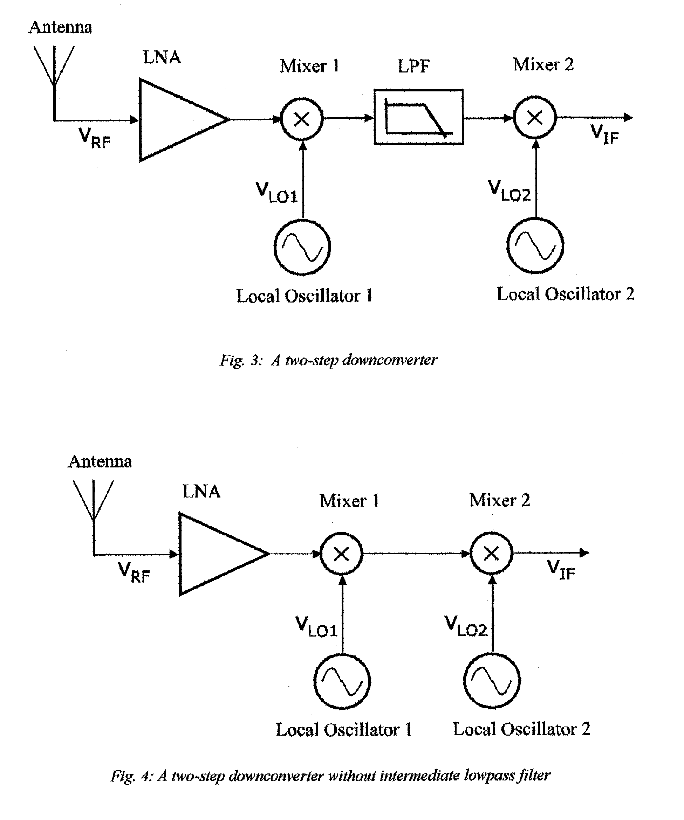

In practice, it is sometimes not obvious to downconvert signal frequencies by more than a factor of 10. E.g. an RF input signal of 5 GHz can be downconverted in one step to a signal of 0.5 GHz. When the desired frequency at the output of the downconverter is even lower than this 0.5 GHz, two downconversion steps are sometimes used (see Fig. 3). In a first downconverter, the signal frequency is converted from $\omega_{RF}$ to $\omega_{IF1} = (\omega_{RF}-\omega_{LO1})$. In a second downconversion step, the signal frequency is further reduced to $\omega IF2 = (\omega_{IF1}-\omega_{LO2}) = (\omega_{RF}-\omega_{LO1}-\omega_{LO2})$. For practical reasons, it is often necessary to insert a lowpass filter in between the two downconverters, to eliminate unwanted signals at the output of the first downconverter. Such a circuit is e.g. described in the *IEEE J. Solid-State Circuits,* Dec. 2000, p. 1908

However, recent developments have shown that in some circumstances, this lowpass filter can be eliminated. The two-step downconverter architecture then reduces to the schematic of Fig. 4.

For sake of completeless, it should be pointed out that, in most practical applications, the Local oscillator signals are not sinusoidal signals, but square-wave signals.

The remaining drawbacks of the circuit of Fig. 4 are its complexity, linearity requirements and, as a result, relatively high power consumption. The invention described in this patent application provides a solution to improve these items.

Although the explanation presented above is focussed on the reception of RF signals, it should be pointed out that mixers are also used for other applications, such as e.g. the emission of RF signals, wireline communications, optical fiber communications, speed detection systems etc. The invention is applicable also to these domains.

## The invention: a two-step downconverter with a single mixer step.

The operation of the mixers in Fig. 4 can be described by means of the following mathematical equations:

$$\nu IF1(t) = \nu_{RF}(t) * \nu_{LO1}(t) \qquad (2a)$$

$$\nu_{IF2}(t) = \nu_{IF1}(t) * \nu_{LO2}(t) \qquad (2b)$$

where $\nu_{IF1}$ and $\nu_{IF2}$ are the signals at the output of the first resp. the second mixer. $\nu_{RF}$ is the input signal. $\nu_{LO1}$ and $\nu_{LO2}$ are the two local oscillator signals.

These expressions can be re-written as:

 (*) Note: Throughout this text, we will denote frequencies with "$\omega$". This symbol denotes in fact the pulsation, equal to $2\pi$ times the frequency.

$$v_{IF2}(t) = \{v_{RF}(t) * v_{LO1}(t)\} * v_{LO2}(t) \tag{3}$$

This can be re-arranged as:

$$v_{IF2}(t) = v_{RF}(t) * \{v_{LO1}(t) * v_{LO2}(t)\} \tag{4}$$

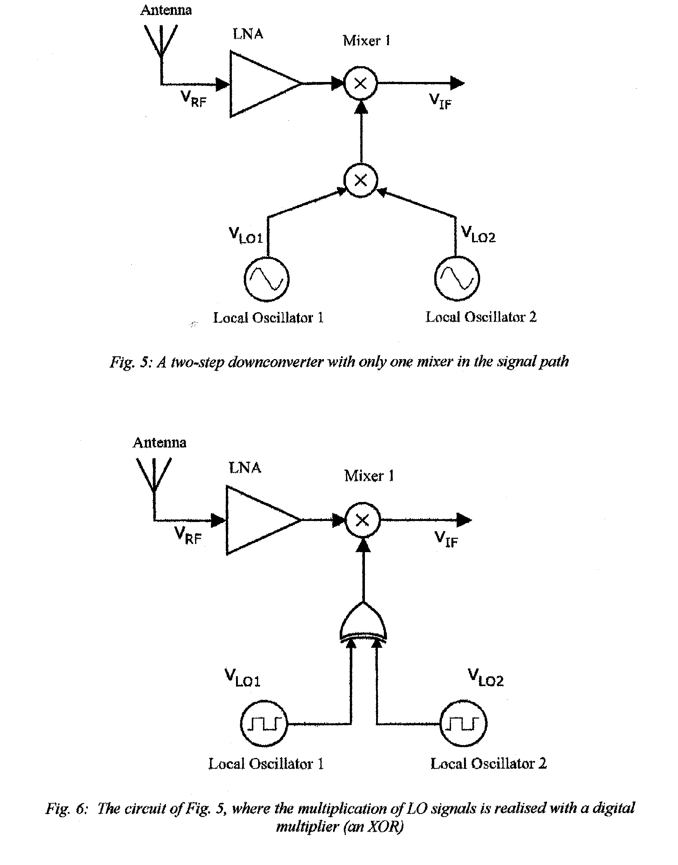

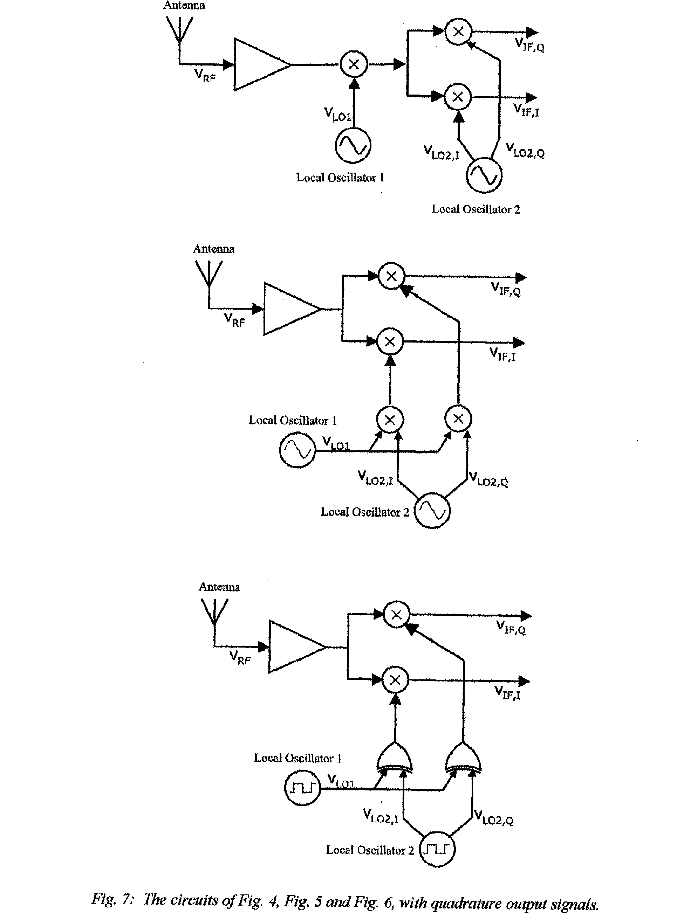

The circuit that realises expression (4) is shown in Fig. 5. Now, there is only one mixer in the signal path. The second mixer is multiplying the two local oscillator signals. Although the ideal behaviour of this circuit is identical to the circuit of Fig. 4, it has superior noise and linearity characteristics, because the second mixer is not in the main signal path. The advantages of the circuit of Fig. 5 become more apparent when realising that, in most practical cases, the two local oscillator signals are (digital) square-wave signals. In this case, the second mixer of Fig. 5 reduces to a simple XOR gate circuit (either standard digital gate, ecl-gate or another kind of digital signal multiplier). This is shown in Fig. 6. The resulting circuit contains only one mixer.

In many applications, it is necessary to obtain two downconverter output signals with a 90 deg. Phase difference. These are called "quadrature signals". Such quadrature output signals can be obtained by modifying the circuit of Fig. 4 into the circuit of Fig. 7a. Now, two mixers are used for the second downconversion step. The different signals in this figure are given by:

$$v_{RF}(t) = A_{RF} * \cos(\omega_{RF}.t) \tag{5a}$$

$$v_{LO1}(t) = A_{LO1} * \cos(\omega_{LO1}.t) \tag{5b}$$

$$v_{LO2,1}(t) = A_{LO2} * \cos(\omega_{LO2}.t) \tag{5c}$$

$$v_{LO2,Q}(t) = A_{LO2} * \sin(\omega_{LO2}.t) \tag{5d}$$

and hence:

$$v_{IF2,I}(t) = v_{RF}(t) * \{v_{LO1}(t) * v_{LO2,I}(t)\}$$

$$= \frac{1}{4}\cos\{(\omega_{RF} + \omega_{LO1} + \omega_{LO2})t\} + \frac{1}{4}\cos\{(\omega_{RF} - \omega_{LO1} + \omega_{LO2})t\} + \tag{6a}$$

$$\frac{1}{4}\cos\{(\omega_{RF} + \omega_{LO1} - \omega_{LO2})t\} + \frac{1}{4}\cos\{(\omega_{RF} - \omega_{LO1} - \omega_{LO2})t\}$$

and

$$v_{IF2,Q}(t) = v_{RF}(t) * \{v_{LO1}(t) * v_{LO2,Q}(t)\}$$

$$= \frac{1}{4}\sin\{(\omega_{RF} + \omega_{LO1} + \omega_{LO2})t\} + \frac{1}{4}\sin\{(\omega_{RF} - \omega_{LO1} + \omega_{LO2})t\} - \quad (6b)$$

$$\frac{1}{4}\sin\{(\omega_{RF} + \omega_{LO1} - \omega_{LO2})t\} - \frac{1}{4}\sin\{(\omega_{RF} - \omega_{LO1} - \omega_{LO2})t\}$$

In practice, only the last terms, with frequency ($\omega_{RF} - \omega_{LO1} - \omega_{LO2}$) in (6a) and (6b) are important. As can be seen, these signals have a 90 degrees phase shift.
Again, the invention allows removing one mixer step in the signal path.
Another aspect of the invention is related to the re-configurable character of the schematics presented in Fig. 6 and Fig. 7: If the signal $V_{LO1}$ Is replaced by a DC signal, all these drawings reduce to a standard single-step mixer architecture. In this way, a reconfigurable mixer architecture is obtained:

- When the signal $V_{LO1}$ is a DC signal (or a digital "1" or "0"), a standard single-step mixer is obtained
- When the signal $V_{LO1}$ is a Local Oscillator signal (sinusoidal, square wave or other), the schematics turn into two-step mixer circuits.

**Claims**

1. A means for deriving an output signal (denoted as $V_{OUT}$) from an input signal (denoted as $V_{RF}$) whereby frequency-domain components in the input signal cause frequency-domain components in the output signal, with frequencies that are equal to the input signal component's frequencies shifted by a given amount, **characterised by** a) the shift between input signal component's frequencies and output signal component's frequencies is equal to the sum of the frequencies of two other signals denoted as $V_{LO1}$ (with frequency $\omega_{LO1}$) and $V_{LO2}$ (with frequency $\omega_{LO2}$) respectively, and b) the signals $V_{LO1}$ and $V_{LO2}$ are combined by a signal combination means, to obtain a third signal (denoted as $V_{LO3}$), and c) the input signal ($V_{RF}$) information is not passing through said signal combination means.

2. A means for deriving an output signal (denoted as $V_{OUT}$) from an input signal (denoted as $V_{RF}$) whereby frequency-domain components in the input signal cause frequency-domain components in the output signal, with frequencies that are equal to the input signal component's frequencies shifted by a given amount, **characterised by** a) the shift between input signal component's frequencies and output signal component's frequencies is equal to the difference of the frequencies of two other signals denoted as $V_{LO1}$ (with frequency $\omega_{LO1}$) and $V_{LO2}$ (with frequency $\omega_{LO2}$) respectively, and b) the signals $V_{LO1}$ and $V_{LO2}$ are combined by a signal combination means, to obtain a third signal (denoted as $V_{LO3}$), and c) the input signal ($V_{RF}$) information is not passing through said signal combination means.

3. A means according to Claims 1 or 2, where $V_{LO1}$ and/or $V_{LO2}$ are signal harmonics of non-sinusoidal signals.

4. A means according to one of the Claims 1 to 3, whereby the combined signal $V_{LO3}$ has significant signal power at frequency $\omega_{LO1} + \omega_{LO2}$ and/or $\omega_{LO1} - \omega_{LO2}$.

5. A means according to Claim 4 **characterised in that** said signal $V_{LO3}$ is obtained by a signal multiplication of signals $V_{LO1}$ and $V_{LO2}$.

6. A means according to Claim 1, 2, 3 or 4, where the two signals $V_{LO1}$ and $V_{LO2}$ are square-wave signals.

7. A means according to Claim 5, where said signals $V_{LO1}$ and $V_{LO2}$ are square-wave signals, and where said multiplication device is performing an XOR function.

8. A means according to one of the Claims 1 to 7, where $V_{RF}$ and $V_{LO3}$ are combined by means of a multiplication device.

9. A means according to one of the Claims 1 to 8, where only one signal multiplication means is present in the signal path between $V_{RF}$ and $V_{OUT}$.

10. A means for deriving two output signals (denoted as $V_{OUT,I}$ and $V_{OUT,Q}$) from an input signal (denoted as $V_{RF}$) whereby frequency-domain components in the input signal cause frequency-domain components in both output signals, with frequencies that are equal to the input signal component's frequencies shifted by a given amount, and where the phase of the signal component in $V_{OUT,I}$ differs by 90 degrees from the phase of the signal component in $v_{OUT,Q}$. This means is further **characterised by** a) it contains two means according to one of the Claims 1 to 9, and b) these two means have a common signal $V_{RF}$ and c) either $V_{LO1}$ or $V_{LO2}$ are common to these two means.

*Fig. 1: A Radio-Frequency receiver*

*Fig. 2: Frequency translation by the mixer*

*Fig. 3: A two-step downconverter*

*Fig. 4: A two-step downconverter without intermediate lowpass filter*

*Fig. 5: A two-step downconverter with only one mixer in the signal path*

*Fig. 6: The circuit of Fig. 5, where the multiplication of LO signals is realised with a digital multiplier (an XOR)*

Fig. 7: The circuits of Fig. 4, Fig. 5 and Fig. 6, with quadrature output signals.

**EP 1 585 227 A1**

<table>
<tr><td colspan="2" align="center">European Patent<br>Office</td><td align="center">**EUROPEAN SEARCH REPORT**</td><td>Application Number<br><br>EP 04 44 7093</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/119470 A1 (PERSICO CHARLES J) 26 June 2003 (2003-06-26) * paragraph [0029] - paragraph [0045]; figures 3-5 * ----- | 1-10 | H04B1/28 H03D7/16 |
| X | US 6 085 075 A (VAN BEZOOIJEN ADRIANUS) 4 July 2000 (2000-07-04) * the whole document * ----- | 1-10 | |
| A | US 2004/014446 A1 (CHAKRABORTY SUDIPTO ET AL) 22 January 2004 (2004-01-22) * the whole document * ----- | 1-10 | |
| X | GB 622 838 A (PHILIPS NV) 9 May 1949 (1949-05-09) * the whole document * ----- | 1 | |
| | | | TECHNICAL FIELDS SEARCHED (Int.Cl.7) H04B H03D H03B H04D |

The present search report has been drawn up for all claims

| Place of search | Date of completion of the search | Examiner |
|---|---|---|
| The Hague | 11 October 2004 | Beasley-Suffolk, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 44 7093

This annex lists the patent family members relating to the patent documents cited in the above-mentioned European search report.
The members are as contained in the European Patent Office EDP file on
The European Patent Office is in no way liable for these particulars which are merely given for the purpose of information.

11-10-2004

| Patent document cited in search report | | Publication date | Patent family member(s) | | Publication date |
|---|---|---|---|---|---|
| US 2003119470 | A1 | 26-06-2003 | EP<br>WO | 1459453 A1<br>03061145 A1 | 22-09-2004<br>24-07-2003 |
| US 6085075 | A | 04-07-2000 | CN<br>EP<br>WO<br>JP | 1246989 T<br>0958657 A1<br>9930420 A1<br>2001510672 T | 08-03-2000<br>24-11-1999<br>17-06-1999<br>31-07-2001 |
| US 2004014446 | A1 | 22-01-2004 | NONE | | |
| GB 622838 | A | 09-05-1949 | BE<br>DE<br>NL | 455967 A<br>890816 C<br>65280 C | <br>21-09-1953<br> |

For more details about this annex : see Official Journal of the European Patent Office, No. 12/82